# EUROPEAN PATENT APPLICATION

(11) **EP 2 945 193 A1**
(43) Date of publication of application: **18.11.2015**
(21) Application number: 15174776.3
(22) Date of filing: 26.10.2010
(51) Int. Cl.: H01L 31/04, H02J 3/38

(54) **PHOTOVOLTAIC POWER GENERATING SYSTEM**

(30) Priority: 10.03.2010 JP 2010053061
(62) Divisional of application: 10847487.5
(71) Applicant: Kabushiki Kaisha Toshiba, Tokyo 105-8001 (JP)
(72) Inventor: Kasai, Chihiro, Tokyo, 105-8001 (JP); Shinohara, Hirofumi, Tokyo, 183-8511 (JP)
(74) Representative: Hoffmann Eitle

(57) **Abstract**

The embodiments comprise a plural solar cell strings 8 each including solar cell modules connected in series, each of solar cell modules configured to generate DC power by radiation of light and a junction box 2 for receiving DC power from plural solar cell strings, wherein junction box includes plural current detectors 10 each for detecting as positive values, currents flowing through certain solar cell strings among plural solar cell strings, detecting as negative values, currents flowing through rest of solar cell strings which are not certain solar cell strings among plural solar cell strings and detecting a total current value in which positive value and negative value are added, a measuring device 11 for measuring, for each of current detectors, total current value detected by current detector, and a data transmitter 12 for transmitting current values measured by measuring device.

## Description

### TECHNICAL FIELD

Embodiments of the present invention relate to a photovoltaic power generating system in which power is generated by use of solar light.

### BACKGROUND ART

In a photovoltaic power generating system, DC power generated from light radiation on solar cell modules is converted into AC power by an inverter, and then the AC power is supplied to an electric power system. The photovoltaic power generating system includes solar cell modules, a junction box, an inverter, a step-up transformer, an AC breaker, an interconnection transformer and an interconnection breaker.

A solar cell module generates DC power when the module is irradiated with light. A solar cell string is formed of multiple solar cell modules connected in series. The solar cell string integrates DC power generated by the solar cell modules and outputs the power between a positive terminal and a negative terminal. The photovoltaic power generating system includes multiple solar cell strings, and the positive terminal and the negative terminal of each of the solar cell strings are connected to the junction box.

The junction box collects the DC power transmitted from the multiple solar cell strings and transmits the power to the inverter. Then the inverter converts the DC power transmitted from the junction box into AC power, and transmits the power to the step-up transformer. The step-up transformer then transforms the AC power transmitted from the inverter into AC power having a predetermined voltage, and transmits the power to the interconnection transformer via the AC breaker. The interconnection transformer transforms the received AC power into a voltage appropriate for interconnection with system power, and transmits the power to the system power via the interconnection breaker. Note that the stronger the light radiated on the solar cell modules, the larger the output current outputted from a solar cell module 1 becomes, and thus larger power can be obtained from the photovoltaic power generating system.

### PRIOR ART DOCUMENT

### PATENT DOCUMENT

Patent Document 1: Japanese patent application publication No. 2006-201827

### SUMMARY OF THE INVENTION

### PROBLEMS TO BE SOLVED BY THE INVENTION

Since the aforementioned conventional photovoltaic power generating system is installed outdoor, solar cell modules used in the photovoltaic power generating system encounter unexpected troubles such as defacement of surface glass due to bird excrement, or breakage of surface glass due to hail. These troubles result in a problem of an unusual heat generation in some of the solar cell modules, for example.

Moreover, the amount of power generation falls short of expectations if defective solar cell modules are neglected, leading to delayed return on investment. In addition, safety hazards also occur, such as burning of the back surface of the solar cell module due to the unusual heat generation. Accordingly, it is required for the photovoltaic power generating system to detect defects in the solar cell modules and to specify the defective solar cell modules.

Meanwhile, when a problem occurs in a certain solar cell module, the output current of the solar cell string including the certain solar cell module drops, and thus occurrence of the problem can be detected by monitoring output currents. However, in a case of using a large-scale photovoltaic power generating system outputting a power of not less than 1000 KW, for example, the number of solar cell strings increases in proportion to an increase in the number of solar cell modules. Therefore, output currents of an immense number of solar cell strings need to be monitored to detect the aforementioned defect, which increases the operation costs. In addition, monitoring of the output currents requires installation of a current detector for every solar cell string. This complicates work for introducing the photovoltaic power generating system.

An object of the present invention is to provide a photovoltaic power generating system that is capable of easily specifying a defective solar cell module when a defect is found in the solar cell modules and also is inexpensive and easily introduced.

### MEANS FOR SOLVING THE PROBLEM

In order to solve the above problem, a photovoltaic power generating system of the embodiments comprises: a plurality of solar cell strings each including solar cell modules connected in series, each of the solar cell modules configured to generate DC power by radiation of light; and a junction box configured to receive DC power from the plurality of solar cell strings, wherein the junction box includes a plurality of current detectors each configured to: detect, as positive values, currents flowing through certain solar cell strings among the plurality of solar cell strings; detect, as negative values, currents flowing through the rest of the solar cell strings which are not the certain solar cell strings among the plurality of solar cell strings; and detect a total current value in which the positive value and the negative value are added, a measuring device configured to measure, for each of the current detectors, the total current value detected by the current detector, and a data transmitter configured to transmit the current values measured by the measuring device.

### BRIEF DESCRIPTION OF THE DRAWINGS

[Fig. 1] Fig. 1 is a diagram showing a configuration of main parts of a photovoltaic power generating system according to a first embodiment.
[Fig. 2] Fig. 2 is a table showing an exemplar configuration of current detectors according to the first embodiment.
[Fig. 3] Fig. 3 is a diagram showing a configuration of main parts of a photovoltaic power generating system according to a second embodiment.
[Fig. 4] Fig. 4 is a diagram showing a configuration of main parts of a photovoltaic power generating system according to a third embodiment.
[Fig. 5] Fig. 5 is a table showing an exemplar configuration of current detectors according to the third embodiment.
[Fig. 6] Fig. 6 is a table showing an exemplar configuration of current detectors according to a modified example of the third embodiment.
[Fig. 7] Fig. 7 is a diagram showing a configuration of main parts of a photovoltaic power generating system according to a fourth embodiment.
[Fig. 8] Fig. 8 is a diagram showing a configuration of main parts of a photovoltaic power generating system according to a fifth embodiment.
[Fig. 9] Fig. 9 is a table showing an exemplar configuration of a current detector according to the fifth embodiment.
[Fig. 10] Fig. 10 is a diagram showing a configuration of main parts of a photovoltaic power generating system according to a modified example of the fifth embodiment.
[Fig. 11] Fig. 11 is a table showing an exemplar configuration of a current detector according to a modified example of the fifth embodiment.
[Fig. 12] Fig. 12 is a diagram showing an exemplar configuration of a current detector and temperature detectors according to a sixth embodiment.

### MODES FOR CARRYING OUT THE INVENTION

Hereinbelow, embodiments will be described in detail with reference to the drawings.

### (First Embodiment)

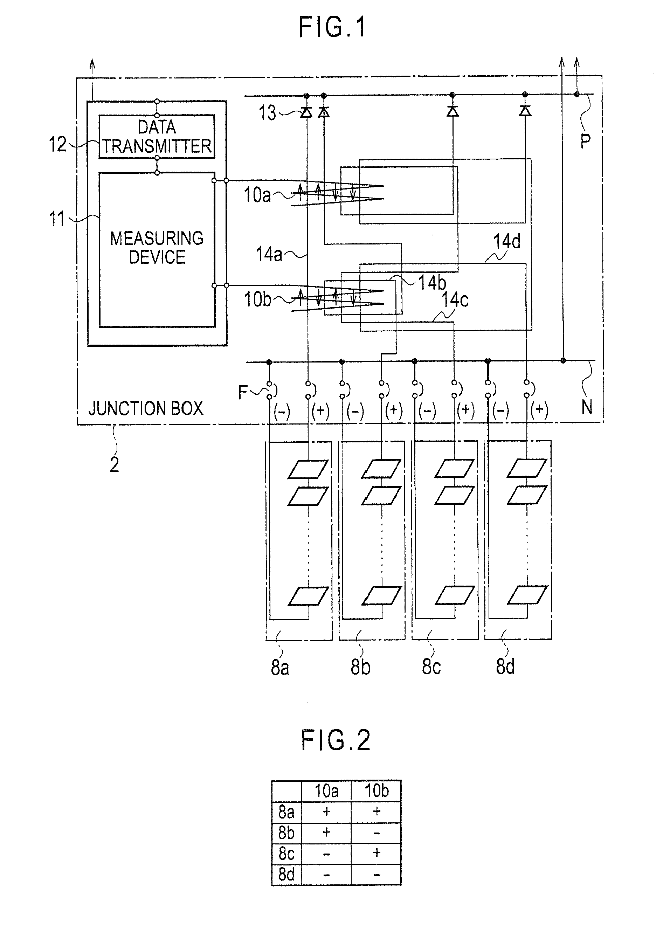

Fig. 1 is a diagram showing a configuration of main parts of a photovoltaic power generating system according to a first embodiment. The photovoltaic power generating system includes solar cell modules, a junction box, an inverter, a step-up transformer, an AC breaker, an interconnection transformer and an interconnection breaker. Note that Fig. 1 only shows multiple solar cell strings 8 and a junction box 2.

The photovoltaic power generating system has a configuration in which the multiple solar cell strings 8a to 8d are connected to the junction box 2. Each of the solar cell strings 8a to 8d is configured in a way that one or multiple solar cell modules 1 are connected in series.

The junction box 2 includes switches F, backflow preventing diodes 13, a positive electrode P, a negative electrode N, current detectors 10a, 10b, a measuring device 11 and a data transmitter 12. A positive terminal (+) of each of the solar cell strings 8a to 8d is connected to the positive electrode P via the switch F, the current detectors 10a, 10b and the backflow preventing diode 13. A negative terminal (-) of each of the solar cell strings 8a to 8d is connected to the negative electrode N via the switch F. The switch F is capable of isolating each of the solar cell strings 8a to 8d from the rest, so that work can be carried out safely at the time of checkup and the like. The backflow preventing diodes 13 prevent backflow of currents flowing from the respective solar cell strings 8a to 8d toward the positive electrode P.

Each of the current detectors 10a, 10b is configured of a current transformer, for example. The current detector 10a is configured to: detect, as positive (+) currents, currents flowing through wirings 14a, 14b extending from the solar cell strings 8a, 8b being inserted therethrough; detect, as negative (-) currents, currents flowing through wirings 14c, 14d extending from the solar cell strings 8c, 8d and being wound one turn; and detect a total of the positive values and the negative values as a total current value.

The current detector 10b is configured to: detect, as positive (+) currents, currents flowing through wirings 14a, 14c extending from the solar cell strings 8a, 8c and inserted therethrough; detect, as negative (-) currents, currents flowing through wirings 14b, 14d extending from the solar cell strings 8b, 8d and wound one turn as; and detect a total of the positive values and the negative values as a total current value. Fig. 2 shows positive or negative polarities of currents flowing through the wirings 14a to 14d extending from the respective solar cell strings 8a to 8d, for each current detector.

A current value signal indicating the detected current value is transmitted to the measuring device 11. The measuring device 11 measures the current value based on the current value signal received from each of the current detectors 10a, 10b, and transmits the values to the data transmitter 12. The data transmitter 12 transmits current data indicating the current values received from the measuring device 11 through wired or wireless communication to the outside.

Subsequently, a description will be given for operations of the photovoltaic power generating system according to the embodiments of the present invention, the system having the above configuration. Power generated in each of the solar cell strings 8a to 8d is outputted from its positive terminal (+) and supplied to the junction box 2. Then, inside the junction box 2, the current from each of the solar cell strings 8a to 8d is forwarded through the switch F, the current detectors 10a, 10b, the backflow preventing diodes 13 and the positive electrode P, and thereafter outputted from the junction box 2.

The current detectors 10a, 10b detect the currents outputted from the multiple solar cell strings 8a to 8d and added as shown in Fig. 2. Each of the detectors then transmits the detected total current value as a current value signal to the measuring device 11. The measuring device 11 measures a current value based on each of the current value signals from the current detectors 10a, 10b, and transmits the current value to the data transmitter 12. The data transmitter 12 transmits the received current value to the outside.

Here, if there is a certain solar cell module 1 with reduced output among the solar cell strings 8a to 8d, current outputted from the corresponding one of the solar cell strings 8a to 8d including the certain solar cell module 1 becomes smaller than current outputted from any other one of the solar cell strings 8a to 8d. For this reason, the total current values of the current detectors 10a, 10b change according to the positive and negative polarities in Fig. 2.

In Fig. 2, the current detectors are configured so that if the current of any of the solar cell strings 8a to 8d drops, the total current values of the respective current detectors 10a, 10b change in a certain direction. In other words, the total current of each of the current detectors 10a, 10b is usually zero if the current of each of the solar cell strings 8a to 8d does not change.

If, however, the current of the solar cell string 8a drops, the direction of the total current of the current detector 10a changes to negative (-), and the direction of the total current of the current detector 10b also changes to negative (-). If the current of the solar cell string 8b drops, the direction of the total current of the current detector 10a changes to negative (-), and the direction of the total current of the current detector 10b changes to positive (+). If the current of the solar cell string 8c drops, the direction of the total current of the current detector 10a changes to positive (+), and the direction of the total current of the current detector 10b changes to negative (-). If the current of the solar cell string 8d drops, the direction of the total current of the current detector 10a changes to positive (+), and the direction of the total current of the current detector 10b also changes to positive (+).

Hence, the measuring device 11 can specify which of the solar cell strings 8a to 8b includes the solar cell module 1 with reduced output, according to the direction (positive or negative direction) in which the total current of each of the current detectors 10a, 10b changes. As a result, time and costs for exchange and maintenance of the solar cell module 1 can be reduced. Additionally, the conventional system requires provision of the current detectors 10a, 10b for every one of the solar cell strings 8a to 8d to achieve the same effects as this embodiment.

On the other hand, this embodiment allows specification of a certain number of the solar cell strings 8a to 8d including a lowered solar cell modules 1, the certain number being exponentially proportional to the number of the current detectors 10. Consequently, the number of necessary current detectors 10 can be drastically reduced, and an inexpensive photovoltaic power generating system can be provided.

Moreover, instant detection of a drop in the output of the solar cell module 1 enables instant exchange of the solar cell module 1 with reduced output. This configuration makes it possible to avoid reduction in the generated power amount due to reduced output of the solar cell module 1. Additionally, since the current values of the solar cell strings 8a to 8d are transmitted to the outside by the data transmitter 12, it is possible to remotely monitor the photovoltaic power generating system.

Note that although in Fig. 1 there are four solar cell strings 8 and two current detectors 10, in the case of a photovoltaic power generating system having n solar cell strings 1, the necessary number of the current detectors 10 is an integer greater than *log₂(n-1).* In this case, the number of possible combinations of direction changes of the total current values detected by the current detectors 10 is not less than n. Accordingly, it is only necessary to configure Fig. 2 so that the total current values of the current detectors 10 change in a certain direction in response to a drop in output of any of the solar cell strings 8a to 8d.

What is more, each of the current detectors 10 may be configured so that wirings 14a to 14d are wound multiple turns, for example, so as to detect currents which are constant multiples of the currents of the solar cell strings 8 (current-detecting magnification factor). Thus, the total current values may be approximated to zero when the respective solar cell strings 8 are irradiated with the same light. In this case, a detecting method using a simple and easy algorithm such as upper and lower threshold limitation control may be employed. Additionally, a current detector of a low rated value may be used, or an AC current detector may be used. Moreover, since there is no need for an actinometer, a system of higher accuracy and lower cost can be achieved.

As has been described, the photovoltaic power generating system according to the first embodiment is capable of easily specifying the solar cell string 8 including the solar cell module 1 with reduced output, by referring to changes in the detected total current values. The system also contributes to reduction of introduction costs. Consequently, the period of reduced output can be shortened, and return on investment can be expedited. In addition, since the photovoltaic power generation system can be monitored remotely, its maintenance is made easier and operation costs can be reduced.

### (Second Embodiment)

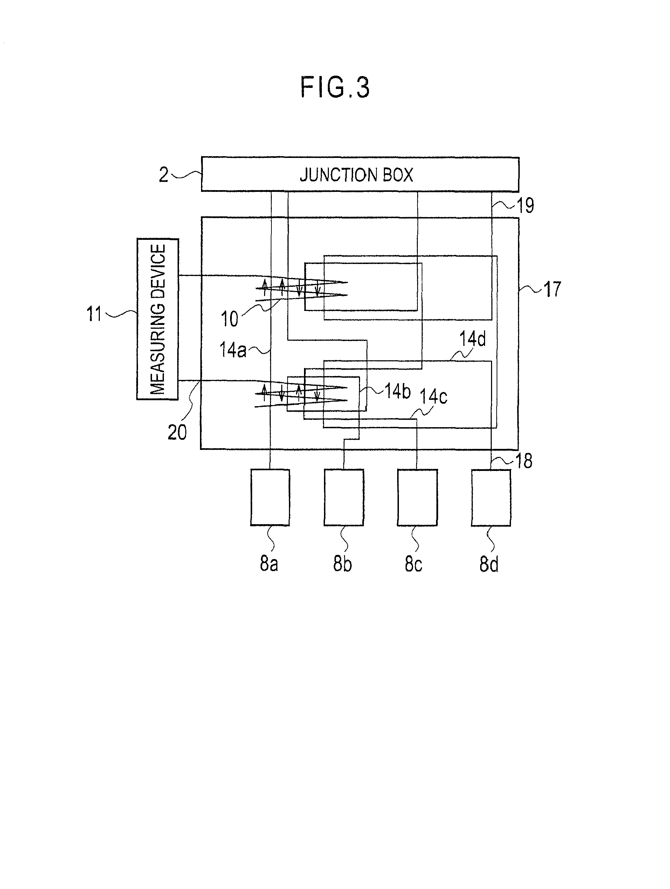

Fig. 3 is a diagram showing a configuration of main parts of a photovoltaic power generating system according to a second embodiment. In the photovoltaic power generating system according to the second embodiment shown in Fig. 3, each of current detectors 10, 20 and wirings 14a to 14d are housed in an enclosure 17. Additionally, solar cell string connection terminals 18 connected to solar cell strings 8a to 8d, junction box connection terminals 19 connected to a junction box 2, and measuring device connection terminals 20 configured to transmit data to a measuring device 11 are exposed to the outside of the enclosure 17.

Although made heavier, the photovoltaic power generation system according to the second embodiment enables easier attachment and detachment of the enclosure 17 to and from the junction box 2, which enhances the versatility of the system. Moreover, wiring errors can be prevented even with a larger number of solar cell strings 8a to 8d, and the solar cell strings 8a to 8d including a solar cell module 1 with reduced output can be detected accurately.

### (Third Embodiment)

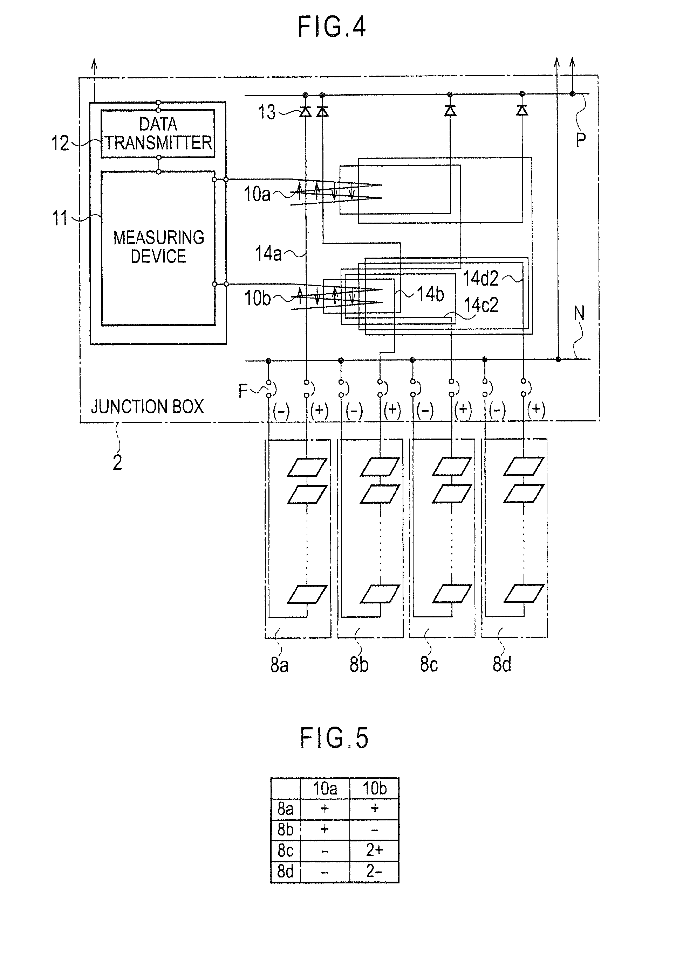

Fig. 4 is a diagram showing a configuration of main parts of a photovoltaic power generating system according to a third embodiment. In Fig. 4, descriptions are omitted for components that are the same as Fig. 1.

Wirings 14c2, 14d2, for example, are wound around a current detector 10b multiple times (such as two turns), so that currents of each of solar cell strings 8a to 8d would be detected in a way that the polarities shown in Fig. 5 are their positive values, and be detected as a value multiplied by the number (such as 2) denoted prior to the polarity in Fig. 5.

If the current detector 10b is configured in this manner, the total current value is not zero even when any two solar cell strings 8 include solar cell modules 1a, 1b with reduced output. Hence, detection is possible even when solar cell modules 1a, 1b whose outputs are similarly reduced are included in different solar cell strings 8.

Although in Fig. 5 there are four solar cell strings 8 and two current detectors 10, in the case of a photovoltaic power generating system having n solar cell strings, the necessary number of the current detectors 10 is an integer greater than *log₂(n-1)*.

In this case, the number of possible combinations of direction changes of total current values detected by the current detector 10 is n. Accordingly, positive and negative polarities in Fig. 5 are configured so that the total current values of the current detectors 10 change in a certain direction in response to a drop in output of any of the solar cell strings 8a to 8d. In addition, the polarities are configured so that the total current values are not zero in a case where any m solar cell strings 8 simultaneously include solar cell modules 1a, 1b, ..., and 1m with reduced output.

With this configuration, even when two or more solar cell strings 8 simultaneously include solar cell modules 1a, 1b, ..., 1m with reduced output, the solar cell strings 8 including the solar cell modules 1a, 1b, ..., 1m with reduced output can be specified.

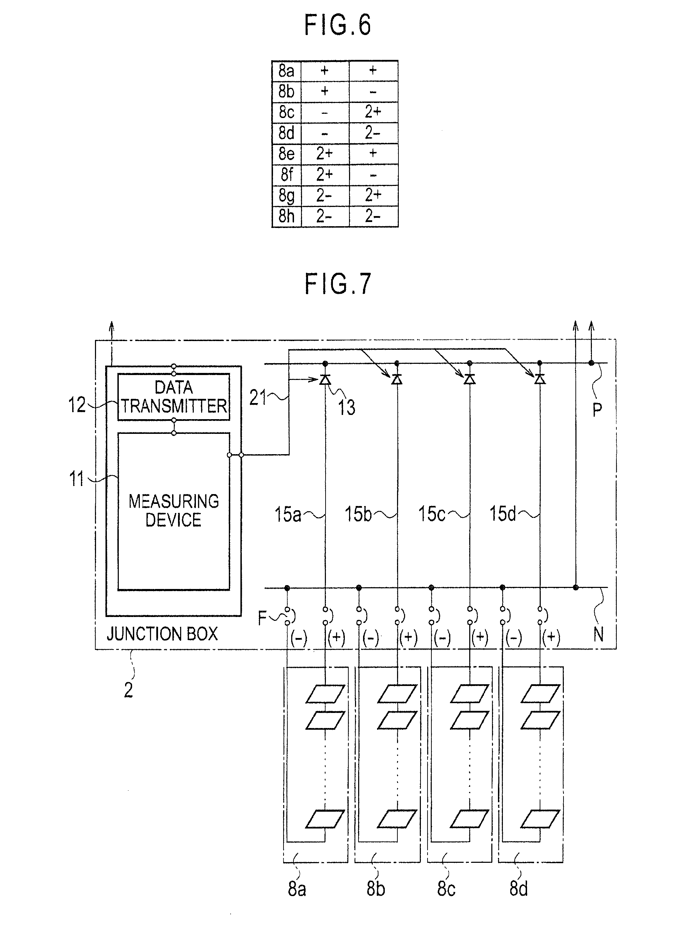

Moreover, as shown in Fig. 6, if the solar cell strings 8 are distinguished from each other not only by the polarities but also by the number of turns, only two current detectors 10 are necessary even when there are eight solar cell strings 8. For example as shown in Fig. 6, winding not only two turns but three or more turns makes it possible to detect an even larger number of solar cell strings 8 with reduced output.

As has been described, the photovoltaic power generating system according to the third embodiment enables specification of the solar cell string 8 even when the solar cell modules 1a, 1b, ..., 1m with reduced output are included in different solar cell strings 8. Accordingly, a photovoltaic power generating system of a higher accuracy can be provided at the same cost, or a system of the same accuracy can be provided at lower costs.

### (Fourth Embodiment)

Fig. 7 is a diagram showing a configuration of main parts of a photovoltaic power generating system according to a fourth embodiment. Note that Fig. 7 only shows multiple solar cell strings 8 and a junction box 2. In Fig. 7, descriptions are omitted for components that are the same as those in the first to third embodiments, and descriptions are given only for the parts different from the embodiments.

The junction box 2 includes a switch F, backflow preventing diodes 13, a positive electrode P, a negative electrode N, a voltage detector 21, a measuring device 11 and a data transmitter 12. A positive terminal (+) of each of the solar cell strings 8a to 8d is connected to the positive electrode P via the switch F and the backflow preventing diode 13. A negative terminal (-) of each of the solar cell strings 8a to 8d is connected to the negative electrode N via the switch F. The switch F is capable of isolating each of the solar cell strings 8a to 8d from the rest, so that work can be carried out safely at the time of checkup and the like. The backflow preventing diodes 13 prevent backflow of currents flowing from the solar cell strings 8a to 8d toward the positive electrode P.

The voltage detector 21 detects voltage at both ends of each of the backflow preventing diodes 13. A voltage value signal indicating the detected voltage value is transmitted to the measuring device 11. The measuring device 11 measures the voltage value based on the voltage value signal received from each of the voltage detectors 21, and transmits the values to the data transmitter 12. The data transmitter 12 transmits data indicating the voltage values received from the measuring device 11 through wired or wireless communication to the outside.

Subsequently, a description will be given for operations of the photovoltaic power generating system according to the fourth embodiment of the present invention, the system having the above configuration. Power generated in each of the solar cell strings 8a to 8d is outputted from its positive terminal

(+) and supplied to the junction box 2. Then, inside the junction box 2, current from the solar cell strings 8a to 8d is forwarded through the switch F, the backflow preventing diodes 13 and the positive electrode P, and thereafter outputted from the junction box 2. At this time, voltage proportional to a corresponding one of the current values of the solar cell strings 8a to 8d is generated at both ends of the backflow preventing diode 13. The voltage detector 21 detects the voltage at both ends of the backflow preventing diode 13 and transmits the voltage as a voltage value signal to the measuring device 11.

Here, if there is a certain solar cell module 1 with reduced output among the solar cell strings 8a to 8d, current outputted from the corresponding one of the solar cell strings 8a to 8d including the certain solar cell module 1 becomes smaller than current outputted from any other one of the solar cell strings 8a to 8d. At this time, the voltage at both ends of the backflow preventing diode 13 connected to a corresponding one of the solar cell strings 8a to 8d including the solar cell module 1 with reduced output becomes smaller than those of the backflow preventing diodes 13 connected to other solar cell strings 8a to 8d. Hence, output reduction of the solar cell module 1 can be detected instantly for each of the solar cell strings 8a to 8d.

In the embodiment, voltage of the backflow preventing diode 13 included in the conventional photovoltaic power generating system is measured by the voltage detector 21 to specify the corresponding one of the solar cell strings 8a to 8d including the solar cell module 1 with reduced output. Consequently, a photovoltaic power generating system which has a high versatility and which is easily introduced can be provided at lower costs, with less additional equipment required as compared to the conventional system. Moreover, use of the voltage detector being less expensive than the current detector 21 can lower the costs even more.

### (Fifth Embodiment)

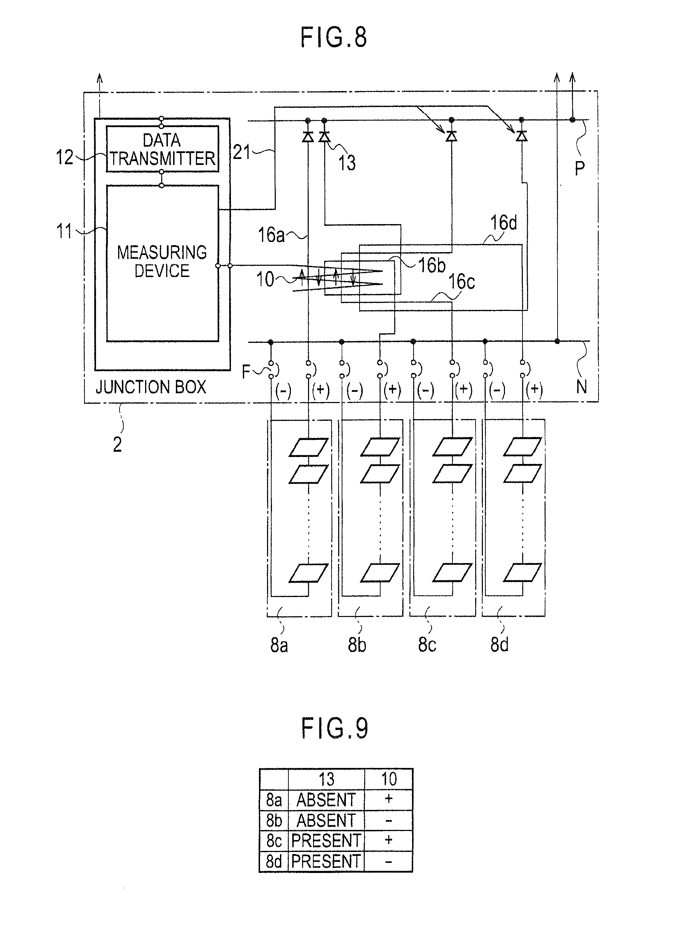

Fig. 8 is a diagram showing a configuration of main parts of a photovoltaic power generating system according to a fifth embodiment. A junction box 2 in the photovoltaic power generating system of the fifth example includes : one or multiple current detectors 10 configured to detect total current values of respective solar cell strings 8a to 8d by detecting the polarities in Fig. 2 as positive values of the currents; and a voltage detector 21 configured to detect voltage at both ends of each of backflow preventing diodes 13.

If there is a certain solar cell module 1 with reduced output among the solar cell strings 8a to 8d, the total current values of the current detector 10 change according to the positive and negative polarities in Fig. 9. Additionally, voltage at both ends of the backflow preventing diode 13 connected to a corresponding one of the solar cell strings 8a to 8d including the solar cell module 1 with reduced output becomes small. Hence, if the voltage detector 21 is provided to the backflow preventing diode 13, the voltage detector 21 detects the voltage at both ends of the backflow preventing diode 13. If the voltage detector 21 is not provided to the backflow preventing diode 13, the voltage at both ends of the backflow preventing diode 13 is not detected.

As can be seen from Fig. 9, the fifth embodiment shown in Fig. 8 shows a case in which the solar cell strings 8a, 8b are not provided with the voltage detector 21, while the solar cell strings 8c, 8d are provided with the voltage detector 21. For this reason, as shown in Fig. 9, the system is set so that a certain solar cell string 8a to 8d including the solar cell module 1 with reduced output is uniquely determined according to directions in which the total current values detected by the current detectors 10 change, and to whether or not voltage reduction is detected by the voltage detector 21. As a result, a drop in output of the solar cell module 1 can be instantly detected for each of the solar cell strings 8a to 8d.

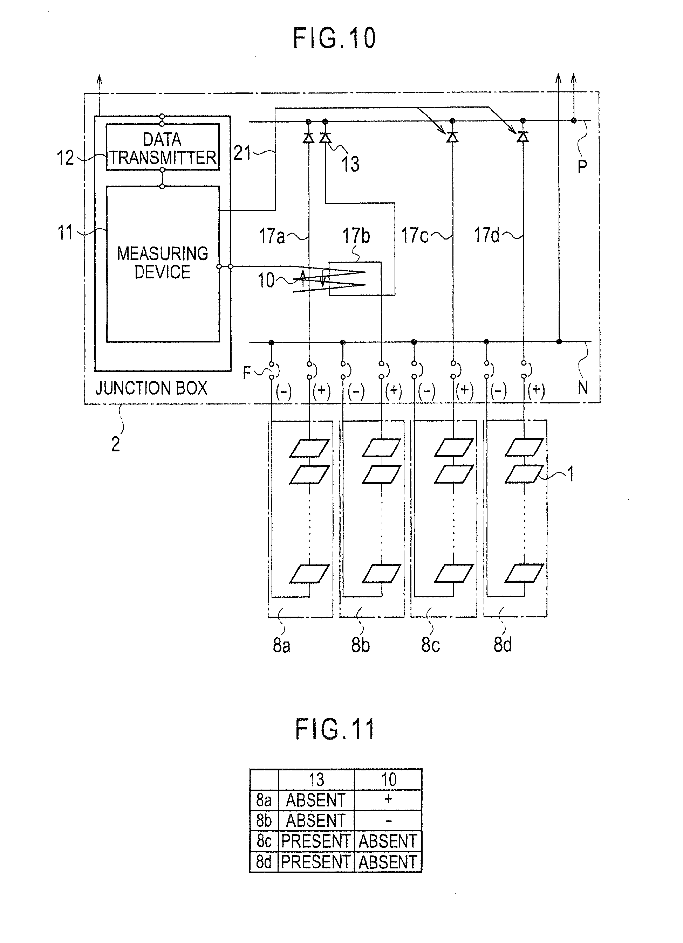

Additionally, as shown in Fig. 10 and Fig. 11 as a modified example of the configuration in Fig. 8 and Fig. 9, a current detector 10 may be configured to add currents flowing through wirings 17a, 17b extending from solar cell strings 8a, 8b, and detect a total current value. It is also possible to uniquely determine a certain solar cell string 8a to 8d including the solar cell module 1 with reduced output by setting the system in the aforementioned way. Hence, a drop in output of the solar cell module 1 can be instantly detected for each of the solar cell strings 8a to 8d.

Thus, the photovoltaic power generating system can be configured even if a junction box 2 is not large enough to install the current detector 10 or the voltage detector 21. On the other hand, if the junction box 2 has enough space, the number of both or either of the current detector 10 and the voltage detector 21 can be increased for provision of a more accurate photovoltaic power generating system.

### (Sixth Embodiment)

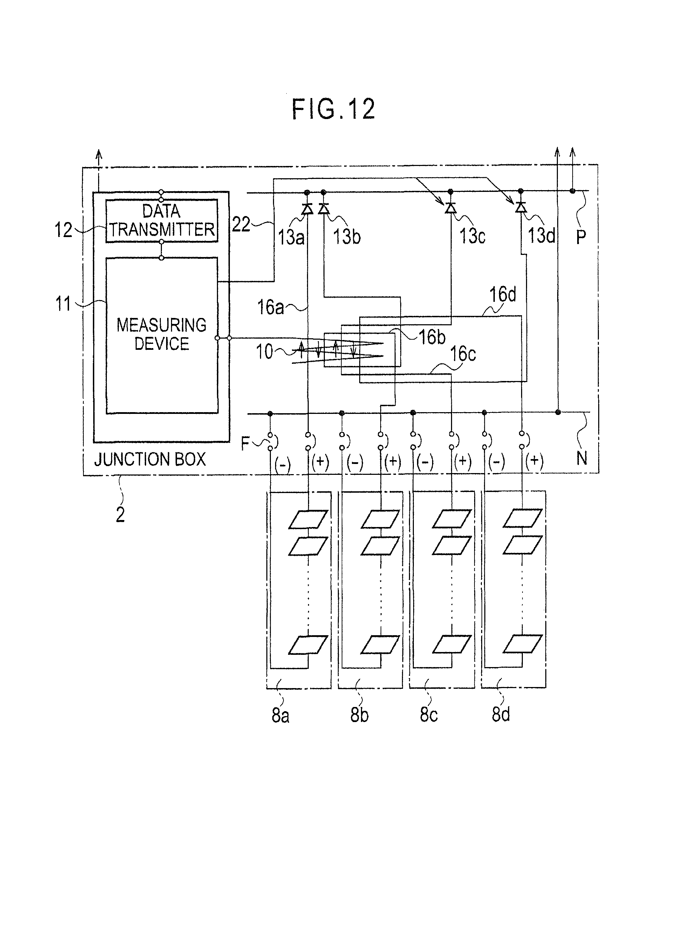

A photovoltaic power generating system according to a sixth embodiment as shown in Fig. 12 is characterized in that a temperature detector 22 is used in place of the voltage detector 21 shown in Fig. 8. If there is a certain solar cell module 1 with reduced output among solar cell strings 8a to 8d, heat of the backflow preventing diode 13 connected to a corresponding one of the solar cell strings 8a to 8d including the solar cell module 1 with reduced output is reduced, and temperature of the diode drops.

If the temperature detector 22 is provided to the backflow preventing diode 13, the temperature detector 22 detects the drop in temperature of the backflow preventing diode 13, and if the temperature detector 22 is not provided to the backflow preventing diode 13, the drop in temperature of the backflow preventing diode 13 is not detected. Specifically, use of the temperature detector 22 produces the same effects as when the voltage detector 21 is used.

Although some embodiments of the present invention have been described, these embodiments are only examples and are not aimed to limit the scope of the invention. These new embodiments can be implemented in other various modes, and various omissions, replacements and modifications can be made without departing from the summary of the invention. These embodiments and modifications thereof are included in the scope and summary of the invention, as well as in the scope of the inventions described in the claims and their equivalents.

Further embodiments E1 to E6 are described in the following.
E1: A photovoltaic power generating system comprising: a plurality of solar cell strings each including solar cell modules connected in series, each of the solar cell modules configured to generate DC power by radiation of light; and a junction box configured to receive the DC power from the plurality of solar cell strings, wherein the junction box includes a plurality of current detectors each configured to: detect, as positive values, currents flowing through certain solar cell strings among the plurality of solar cell strings; detect, as negative values, currents flowing through the rest of the solar cell strings which are not the certain solar cell strings among the plurality of solar cell strings; and detect a total current value in which the positive value and the negative value are added, a measuring device configured to measure, for each of the current detectors, the total current value detected by the current detector, and a data transmitter configured to transmit the current values measured by the measuring device.
E2: The photovoltaic power generating system according to embodiment 1, wherein the measuring device is configured to specify the solar cell string including the solar cell module with reduced output, according to directions in which the total current values detected by each of the current detectors change.
E3: The photovoltaic power generating system according to embodiment 1, wherein each of the plurality of current detectors is configured to adjust the current-detecting magnification factors of the plurality of solar cell strings, so that the detected total current value approximates zero.
E4: The photovoltaic power generating system according to embodiment 1, wherein the plurality of current detectors and wirings are housed in an enclosure; and solar cell string connection terminals connected to the solar cell strings, a junction box connection terminal connected to the junction box, and a measuring device connection terminal configured to transmit data to the measuring device are exposed to the outside of the enclosure.
E5: A photovoltaic power generating system comprising: a plurality of solar cell strings including solar cell modules connected in series, each of the solar cell modules generating DC power by radiation of light; and a junction box configured to receive the DC power from the plurality of solar cell strings, wherein the junction box includes backflow preventing diodes configured to prevent backflow of currents generated by the solar cell strings, a voltage detector configured to detect voltage at both ends of the backflow preventing diode, a measuring device configured to measure the voltage detected by the voltage detector, and a data transmitter configured to transmit a voltage value measured by the measuring device.
E6: A photovoltaic power generating system comprising: a plurality of solar cell strings including solar cell modules connected in series, each of the solar cell modules generating DC power by radiation of light; and a junction box configured to receive DC power from the plurality of solar cell strings, wherein the junction box includes backflow preventing diodes configured to prevent backflow of currents generated by the solar cell strings, a temperature detector configured to detect the temperature of the backflow preventing diode, a measuring device configured to measure the temperature detected by the temperature detector, and a data transmitter configured to transmit a temperature value measured by the measuring device.

## Claims

1. A photovoltaic power generating system comprising:
a plurality of solar cell strings each including solar cell modules connected in series, each of the solar cell modules configured to generate DC power by radiation of light;
a junction box configured to receive the DC power from the plurality of solar cell strings,
a plurality of current detectors each configured to:
detect, as positive values, currents flowing through certain solar cell strings among the plurality of solar cell strings;
detect, as negative values, currents flowing through the rest of the solar cell strings which are not the certain solar cell strings among the plurality of solar cell strings; and detect a total current value in which the positive value and the negative value are added,
a measuring device configured to measure, for each of the current detectors, the total current value detected by the current detector, **characterized by** the plurality of current detectors and wirings are housed in an enclosure; and
solar cell string connection terminals connected to the solar cell strings,
a junction box connection terminal connected to the junction box, and
a measuring device connection terminal configured to transmit data to the measuring device
are exposed to the outside of the enclosure.

2. The photovoltaic power generating system according to claim 1, wherein the measuring device is configured to specify the solar cell string including the solar cell module with reduced output, according to directions in which the total current values detected by each of the current detectors change .

3. The photovoltaic power generating system according to claim 1, wherein each of the plurality of current detectors is configured to adjust the current-detecting magnification factors of the plurality of solar cell strings, so that the detected total current value approximates zero.
